# DEMANDE DE BREVET EUROPEEN

(11) **EP 1 282 158 A1**
(43) Date de publication de la demande: **05.02.2003**
(21) Numéro de dépôt: 02354116.2
(22) Date de dépôt: 29.07.2002
(51) Int. Cl.: H01L 21/225, H01L 21/331, H01L 21/8249

(54) **Prcédé de fabrication de transistor bipolaire dans une circuit intégré CMOS**

(30) Priorité: 31.07.2001 FR 0110270
(71) Demandeur: STMicroelectronics S.A., 92120 Montrouge (FR)
(72) Inventeur: Menut, Olivier, 38000 Grenoble (FR); Jaouen, Hervé, 38240 Meylan (FR); Bouche, Guillaume, 38000 Grenoble (FR)
(74) Mandataire: de Beaumont, Michel

(57) **Abrégé**

L'invention concerne un procédé de fabrication d'un contact (27) entre un substrat semiconducteur (10) et une couche de silicium polycristallin (20) dopée déposée sur le substrat (10) avec interposition d'une couche isolante (19), caractérisé en ce que l'on implante à travers la couche de silicium polycristallin (20) des éléments propres à rendre la couche isolante (19) perméable à la migration de dopants en provenance de la couche de silicium polycristallin (20). L'invention concerne également un procédé de fabrication d'un circuit intégré comprenant notamment un transistor MOS à canal d'un premier type de conductivité et un transistor bipolaire du type à émetteur-collecteur d'un second type de conductivité comportant une zone de contact selon l'invention.

## Description

La présente invention concerne le domaine de la fabrication des circuits intégrés.

Avec les progrès de la technologie, on voit actuellement se développer des circuits intégrés de plus en plus complexes intégrant un grand nombre de composants de types différents : en particulier des transistors CMOS et des transistors bipolaires. La réalisation classique de telles structures entraîne la prévision d'un grand nombre d'étapes de fabrication du fait que l'on doit ajouter aux étapes de fabrication d'un circuit CMOS des étapes spécifiques à la réalisation des transistors bipolaires.

C'est donc un objet constant de la recherche dans le domaine de la fabrication des circuits intégrés que de rechercher des procédés de fabrication permettant d'optimiser simultanément des composants de types différents tout en minimisant le nombre d'étapes de fabrication. En particulier, on cherche à rendre commune le plus grand nombre d'étapes lors de l'élaboration des transistors bipolaires et des transistors MOS sur un circuit intégré.

La présente invention vise la fabrication simultanée de transistors bipolaires et de transistors MOS sur un même circuit intégré dans laquelle un grand nombre d'étapes de fabrication du transistor bipolaire demeurent communes avec les étapes de fabrication des transistors MOS.

Plus précisément, la présente invention vise la fabrication d'un émetteur de transistor bipolaire de façon similaire à la fabrication de la grille d'un transistor MOS.

Plus généralement, la présente invention vise à réaliser un contact entre une couche de silicium polycristallin dopée et un substrat sous-jacent nonobstant la présence d'une couche isolante mince entre ceux-ci.

Pour atteindre ces objets, la présente invention prévoit un procédé de fabrication d'un contact entre un substrat semiconducteur et une couche de silicium polycristallin dopée déposée sur le substrat avec interposition d'une couche isolante, dans lequel on implante à travers la couche de silicium polycristallin des éléments propres à rendre la couche isolante perméable à la migration de dopants en provenance de la couche de silicium polycristallin vers le substrat.

Selon un mode de réalisation de la présente invention, la couche isolante est une couche d'oxyde de silicium.

Selon un mode de réalisation de la présente invention, lesdits éléments sont constitués d'hydrogène.

Selon un mode de réalisation de la présente invention, lesdits éléments sont constitués de silicium ou de germanium.

La présente invention prévoit également un procédé de fabrication de la zone d'émetteur d'un transistor bipolaire dans une plaquette de circuit intégré de type CMOS, comportant les étapes de former sur la plaquette une couche isolante surmontée d'une couche de silicium polycristallin sur l'ensemble du circuit intégré ; dans la zone du transistor bipolaire, implanter à travers la couche de silicium polycristallin des éléments propres à rendre la couche isolante perméable à la migration de dopants en provenance de la couche de silicium polycristallin ; et éliminer la couche de silicium polycristallin et la couche isolante en dehors des emplacements où l'on veut former l'émetteur du transistor bipolaire et les grilles des transistors MOS.

Selon un mode de réalisation de la présente invention, la couche isolante est une couche d'oxyde de silicium.

Selon un mode de réalisation de la présente invention, l'étape d'implantation comprend l'implantation de silicium ou de germanium.

Selon un mode de réalisation de la présente invention, l'étape d'implantation comprend l'implantation d'hydrogène.

La présente invention vise également un procédé de fabrication d'un transistor bipolaire dans un circuit intégré de type CMOS, comprenant les étapes de former dans le substrat du circuit intégré une région propre à former la zone de collecteur du transistor bipolaire ; implanter dans la région, une région dopée propre à former la base du transistor bipolaire ; et former l'émetteur du transistor bipolaire par le procédé mentionné précédemment.

La présente invention vise également un procédé de fabrication de la zone d'émetteur d'un transistor bipolaire dans un circuit intégré de type CMOS, comportant les étapes consistant à implanter dans la zone du transistor bipolaire un élément adapté à empêcher la formation d'une isolant électrique sur ladite zone ; former sur l'ensemble du circuit intégré en dehors de la zone implantée une région électriquement isolante ; former une couche en silicium polycristallin sur l'ensemble du circuit intégré ; et éliminer la couche de silicium polycristallin et la région électriquement isolante en dehors des emplacements où l'on veut former l'émetteur du transistor bipolaire et les grilles des transistor MOS.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 6 sont des vues en coupe schématiques illustrant des étapes successives de fabrication simultanée d'un transistor MOS et d'un transistor bipolaire ; et
les figures 7 à 9 sont des vues en coupe schématiques illustrant un troisième mode de réalisation des étapes des figures 3 à 6.

On notera que dans ces diverses figures, comme cela est usuel dans la représentation des circuits intégrés, les épaisseurs et dimensions latérales des diverses couches ne sont pas tracées à l'échelle ni à l'intérieur d'une même figure ni d'une figure à l'autre pour améliorer la lisibilité de ces figures. Par ailleurs, de mêmes références désigneront de mêmes éléments ou couches, éventuellement à des stades successifs de fabrication. Enfin, seules les étapes caractéristiques du procédé selon l'invention seront décrites en détail par la suite, les étapes intermédiaires bien connues de l'homme de l'art ne seront pas mentionnées.

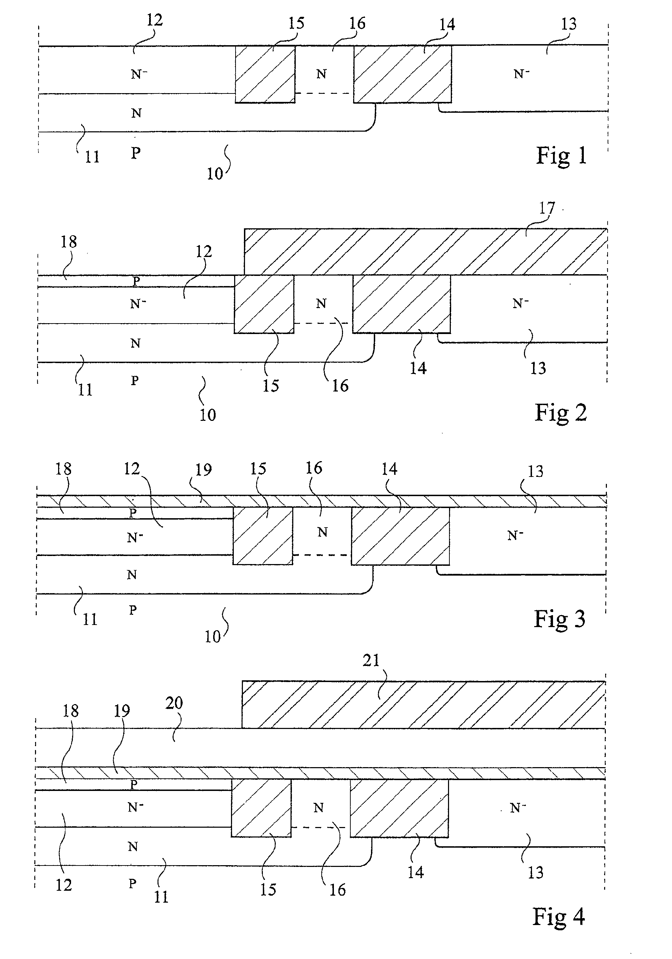

On va décrire ci-après, à titre d'exemple, la formation sur un circuit intégré d'un transistor MOS à canal P dans la partie droite et la fabrication d'un transistor bipolaire de type NPN dans la partie gauche des figures 1 à 6. Bien sûr, parallèlement à la formation de transistors de type NPN, et de transistors MOS à canal P, sont également formés sur le circuit intégré des transistors MOS à canal N qui ne sont pas représentés sur les figures pour plus de clarté.

La figure 1 représente une plaquette de circuit intégré comprenant un substrat semiconducteur 10 de type P. Du côté du transistor bipolaire, une région 11 de type N est surmontée d'une région 12 de type N moins dopée. Du côté du transistor MOS à canal P, une région 13 de type N est formée en même temps que la région 12. Une tranchée principale 14 remplie d'isolant, par exemple de l'oxyde de silicium, sépare la zone de transistor bipolaire de celle du transistor MOS à canal P. Du côté du transistor bipolaire, une tranchée auxiliaire 15 remplie d'isolant, délimite avec la tranchée principale 14, un puits 16 de type N reliant la surface de la plaquette à la région 11 de type N, située sous la région 12 de type N.

Sur la figure 2, un masque 17 recouvre la zone du transistor MOS à canal P. Un dopant de type P est implanté, de façon à former une région 18 de type P à la surface de la région 12 de type N de la zone du transistor bipolaire. Cette région 18 est destinée à former la base du transistor bipolaire.

A l'étape représentée sur la figure 3, on fait croître sur toute la surface extérieure de la plaquette une couche d'oxyde de grille 19, par exemple de l'oxyde de silicium, ayant par exemple une épaisseur de 1,5 nm.

Sur la figure 4 est représentée une couche de silicium polycristallin 20, ayant par exemple une épaisseur de 0,2 µm, déposée sur la couche d'oxyde de grille 19, et recouverte, au niveau de la zone du transistor MOS à canal P, par un masque 21.

Selon un premier mode de réalisation de l'invention, on réalise alors une implantation d'hydrogène dans la couche d'oxyde 19 à travers la couche de silicium polycristallin 20 non protégée par le masque 21, c'est-à-dire au niveau de la zone du transistor bipolaire. L'implantation est réalisée par exemple sous une énergie 10 keV, et avec une dose de 10¹⁵ at/cm² à 10¹⁷ at/cm². La couche de silicium polycristallin 20 est dopée de type N au niveau du transistor bipolaire et des transistors MOS à canal N (non représentés), et est dopée de type P au niveau du transistor MOS à canal P.

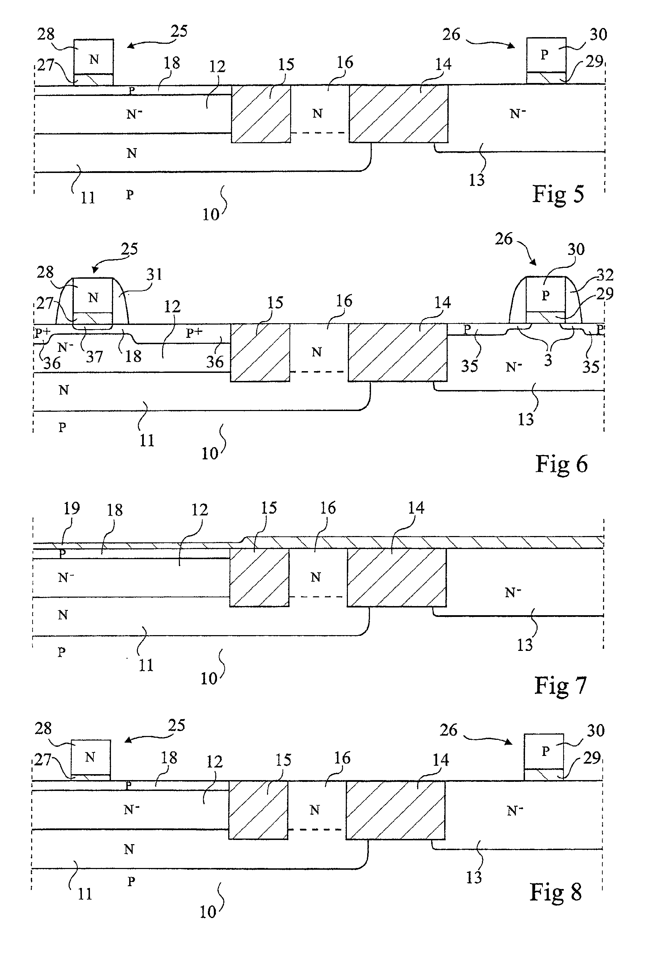

La figure 5 illustre la structure obtenue après élimination de la couche de silicium polycristallin 20 et de l'oxyde de grille 19 excepté sur les emplacements où l'on veut former l'émetteur du transistor bipolaire et la grille du transistor MOS à canal P. Du côté du transistor bipolaire, on obtient un premier empilement 25 constitué d'une portion 27 de la couche d'oxyde de grille 19 dans laquelle une implantation d'hydrogène a été réalisée, surmontée d'une portion 28 de la couche de silicium polycristallin 20. Du côté du transistor MOS à canal P, un second empilement 26 destiné à former la grille du transistor MOS à canal P, comprend également une portion 29 non modifiée de la couche d'oxyde de grille 19 surmontée d'une portion 30 de la couche de silicium polycristallin 20.

La figure 6 présente schématiquement des étapes ultérieures de réalisation des transistors. On réalise une implantation de dopants de type P pour former, de part et d'autre du second empilement 26, des régions désignées par la référence 33. Suite à cette implantation, on forme des espaceurs désignés par la référence 31 au niveau du premier empilement 25 du côté du transistor bipolaire et désignés par la référence 32 au niveau du second empilement 26 du côté du transistor MOS à canal P. Ensuite, une deuxième implantation de dopants de type P est réalisée, pour former des régions fortement dopées de part et d'autre des premier et second empilements. On forme ainsi les régions 36 de base extrinsèque du transistor bipolaire et des régions 35 de drain et de source du transistor à canal P.

Un recuit d'activation est en général réalisé à cette étape, par exemple à une température de 1000°C et pendant une durée de 10 secondes. Lors de ce recuit, l'hydrogène implanté dans la portion 27 d'oxyde de grille du côté du transistor bipolaire, se combine, selon une réaction classique d'oxydoréduction, avec les molécules de SiO₂.

La réduction de la portion 27 d'oxyde de grille par l'hydrogène en modifie les propriétés. En particulier, cette portion d'oxyde 27 ne s'oppose plus à la migration des dopants de type N présents dans la portion 28 de silicium polycristallin vers la région 18 de type P, pour former une zone d'émetteur 37. On obtient ainsi un transistor de type NPN dont l'émetteur correspond à la région 37 en contact avec la portion 28 de silicium polycristallin, la base correspond à la région 18 dopée P s'étendant jusqu'aux régions de base extrinsèque 36, et le collecteur correspond à la région 12 de type N se prolongeant par la région 11 et le puits 16. En outre, lors du fonctionnement du transistor de type NPN, la portion d'oxyde 27 ne s'oppose plus au passage des porteurs de charge, c'est-à-dire que la portion d'oxyde 27 devient conductrice.

Selon un deuxième mode de réalisation de la présente invention, au lieu d'implanter de l'hydrogène dans la couche d'oxyde de grille 19, on implante du silicium ou du germanium. L'implantation est réalisée, par exemple, avec une dose de 10¹⁵ à 10¹⁷ atomes/cm². Un facteur important à cette étape est le flux avec lequel le silicium ou le germanium sont implantés. En effet, les ions de silicium ou de germanium viennent altérer la structure de la couche d'oxyde de grille 19. Cette altération de l'oxyde se produit essentiellement pendant l'implantation des ions de silicium ou de germanium et non lors du recuit d'activation comme c'était le cas pour le premier mode de réalisation. Le flux de silicium ou de germanium sera par exemple de 10 à 100 µA.

L'implantation de silicium ou de germanium risque d'abîmer les couches sous-jacentes, c'est-à-dire la région de base 18 de type P. Toutefois, lors d'une des étapes de recuits, on aura une reconstruction du matériau cristallin.

Un troisième mode de réalisation de la présente invention est représenté sur les figures 7 à 9. Une implantation d'azote sur la zone du transistor bipolaire est réalisée avant la formation de la couche d'oxyde de grille 19, dans la région 18 de type P destinée à former la base du transistor bipolaire. L'implantation d'azote est effectuée, par exemple, à une dose de 10¹⁴ à 10¹⁶ at/cm².

Comme cela est représenté sur la figure 7, quand on fait croître la couche d'oxyde de grille 19 sur l'ensemble de la plaquette du circuit intégré, la présence des implants d'azote réduit la croissance de l'oxyde au niveau de la région 18 de type P. Ainsi, lorsque l'on fait croître la couche d'oxyde de grille 19 pour obtenir une épaisseur moyenne de 1,2 nm au niveau du transistor MOS à canal P, on obtient au niveau du transistor bipolaire une couche d'oxyde de grille 19, présentant une épaisseur moyenne de 0,8 nm. On fait croître alors une couche de silicium polycristallin 20 comme dans les modes de réalisation précédemment décrits.

La figure 8 représente deux empilements 25, 26 restant en place après l'élimination de la couche de silicium polycristallin 20 et de l'oxyde de grille 19. L'empilement 25, situé du côté du transistor bipolaire, présente une portion 27 de d'oxyde de grille modifiée par rapport à celle de l'empilement 26 situé du côté du transistor MOS à canal P.

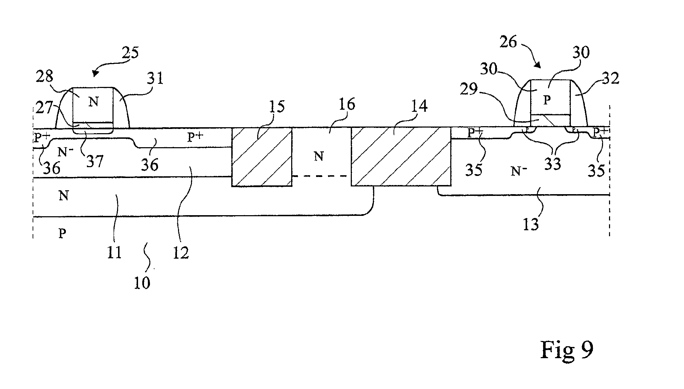

La figure 9 représente les étapes finales de ce troisième mode de réalisation qui sont identiques à celles des modes de réalisation précédents. La présence de la couche d'oxyde très mince 27 autorise la diffusion des dopants présents dans la portion 28 de silicium polycristallin lors du recuit d'activation, pour former une zone d'émetteur 37.

Selon une variante du troisième mode de réalisation, on peut utiliser à la place de l'azote tout élément adapté à empêcher la croissance sur la zone du transistor bipolaire d'une couche d'oxyde ou au moins à limiter l'épaisseur de la couche d'oxyde formée sur la zone du transistor bipolaire de sorte que la couche d'oxyde localement mince autorise, au niveau de la zone du transistor bipolaire, la diffusion des dopants présents dans la portion 28 de silicium polycristallin.

Ainsi selon les modes de réalisation de la présente invention, il devient possible de fabriquer sur un circuit intégré des transistors de type MOS et des transistors bipolaires avec un minimum d'étapes spécifiques au transistor bipolaire. Les différences essentielles consistent d'une part en l'implantation d'une région dopée P, correspondant par exemple à l'implantation des sources et drains du transistor MOS à canal P, pour constituer la base intrinsèque du transistor NPN et d'autre part en l'étape consistant à modifier la couche d'oxyde de grille de façon à ce qu'elle ne s'oppose pas au passage des dopants, lors du recuit d'activation, pour former la zone d'émetteur.

Dans ce qui précède, on a décrit des modes de réalisation particuliers de la présente invention. Il est clair que ces réalisations sont susceptibles de variantes et de modifications qui apparaîtront à l'homme de l'art. Notamment, tous les types de conductivité pourraient être inversés pour former simultanément un transistor MOS à canal N et un transistor bipolaire PNP.

En outre, bien que la présente invention ait été décrite dans le cadre de la fabrication sur un circuit intégré de transistors de type MOS et de transistors bipolaires, elle peut s'appliquer à la fabrication simultanée sur un circuit intégré de transistors de type MOS et de transistors à effet de champ à jonction JFET, la jonction de commande du transistor à effet de champ JFET est alors obtenue de façon similaire à la région d'émetteur du transistor bipolaire selon le procédé de la présente invention.

## Revendications

1. Procédé de fabrication d'un contact (27) entre un substrat semiconducteur (10) et une couche de silicium polycristallin (20) dopée déposée sur le substrat (10) avec interposition d'une couche isolante (19), **caractérisé en ce que** l'on implante à travers la couche de silicium polycristallin (20) des éléments propres à rendre la couche isolante (19) perméable à la migration de dopants en provenance de la couche de silicium polycristallin (20) vers le substrat.

2. Procédé de fabrication selon la revendication 1, **caractérisé en ce que** la couche isolante (19) est une couche d'oxyde de silicium.

3. Procédé de fabrication selon la revendication 2, **caractérisé en ce que** lesdits éléments sont constitués d'hydrogène.

4. Procédé de fabrication selon la revendication 2, **caractérisé en ce que** lesdits éléments sont constitués de silicium ou de germanium.

5. Procédé de fabrication de la zone d'émetteur d'un transistor bipolaire dans une plaquette de circuit intégré de type CMOS, **caractérisé en ce qu'**il comporte les étapes suivantes :
- former sur la plaquette une couche isolante (19) surmontée d'une couche de silicium polycristallin (20) sur l'ensemble du circuit intégré ;
- dans la zone du transistor bipolaire, implanter à travers la couche de silicium polycristallin (20) des éléments propres à rendre la couche isolante (19) perméable à la migration de dopants en provenance de la couche de silicium polycristallin (20) ; et
- éliminer la couche de silicium polycristallin (20) et la couche isolante (19) en dehors des emplacements où l'on veut former l'émetteur du transistor bipolaire et les grilles des transistor MOS.

6. Procédé de fabrication selon la revendication 5, **caractérisé en ce que** la couche isolante (19) est une couche d'oxyde de silicium.

7. Procédé selon la revendication 6, **caractérisé en ce que** l'étape d'implantation comprend l'implantation de silicium ou de germanium.

8. Procédé selon la revendication 6, **caractérisé en ce que** l'étape d'implantation comprend l'implantation d'hydrogène.

9. Procédé de fabrication d'un transistor bipolaire dans un circuit intégré de type CMOS, **caractérisé en ce qu'**il comprend les étapes suivantes :
- former dans le substrat (10) du circuit intégré une région (11,12) propre à former la zone de collecteur du transistor bipolaire ;
- implanter dans la région (12), une région dopée (18) propre à former la base du transistor bipolaire ; et
- former l'émetteur (27,37) du transistor bipolaire par le procédé selon la revendication 5.

10. Procédé de fabrication de la zone d'émetteur d'un transistor bipolaire dans un circuit intégré de type CMOS, **caractérisé en ce qu'**il comporte les étapes suivantes :
- implanter dans la zone du transistor bipolaire un élément adapté à empêcher la formation d'une zone électriquement isolante sur la zone du transistor bipolaire ;
- former sur l'ensemble du circuit intégré en dehors de la zone implantée une région électriquement isolante (19) ;
- former une couche en silicium polycristallin (20) sur l'ensemble du circuit intégré ; et
- éliminer la couche de silicium polycristallin (20) et la région électriquement isolante (19) en dehors des emplacements où l'on veut former l'émetteur du transistor bipolaire et les grilles des transistor MOS.
